# FASCICULE DE BREVET EUROPEEN

(11) **EP 1 256 132 B1**
(45) Date de publication et mention de la délivrance du brevet: **09.05.2018**
(21) Numéro de dépôt: 01905860.1
(22) Date de dépôt: 30.01.2001
(51) Int. Cl.: H01L 25/10, H01L 21/98

(54) **PROCEDE D'INTERCONNEXION ELECTRIQUE EN TROIS DIMENSIONS ENTRE DES PUCES ELECTRONIQUES ENCAPSULEES OU ENTRE UNE PUCE ELECTRONIQUE ENCAPSULEE ET UN CIRCUIT IMPRIME**
VERFAHREN ZUR DREIDIMENSIONALEN ELEKTRISCHEN VERBINDUNG ZWISCHEN EINGEKAPSELTEN ELEKTRONISCHEN CHIPS ODER ZWISCHEN EINEM EINGEKAPSELTEN ELEKTRONISCHEN CHIP UND EINER LEITERPLATTE
METHOD OF THREE-DIMENSIONAL ELECTRICAL INTERCONNECTION BETWEEN ENCAPSULATED ELECTRONIC CHIPS OR BETWEEN AN ENCAPSULATED ELECTRONIC CHIP AND A PRINTED CIRCUIT

(30) Priorité: 11.02.2000 FR 0001750
(43) Date de publication de la demande: 13.11.2002
(73) Titulaire: 3D Plus, 78530 Buc (FR)
(72) Inventeur: VAL, Christian, F-94117 Arcueil Cedex (FR)
(74) Mandataire: Esselin, Sophie
(86) Numéro de dépôt international: PCT/FR2001/000283
(87) Numéro de publication internationale: WO 2001/059841

(56) Documents cités:
- US-A- 3 370 203
- US-A- 5 400 218
- US-A- 5 637 536
- US-A- 5 885 850

## Description

L'invention se rapporte à un procédé d'interconnexion en trois dimensions pour boîtiers contenant au moins un composant électronique.

La réalisation des systèmes électroniques actuels, tant civils que militaires, doit tenir compte d'exigences de plus en plus grandes de compacité, du fait du nombre de plus en plus élevé de circuits mis en oeuvre.

Dans cette recherche de plus grande compacité, il a déjà été proposé de réaliser des empilements de puces de circuits intégrés comme décrit dans le brevet américain US 5 637 536 A ou, comme décrit dans le brevet français FR 2 688 630, de boîtiers encapsulant des puces, l'interconnexion s'effectuant en trois dimensions en utilisant les faces de l'empilement comme surfaces d'interconnexion pour réaliser les connexions entre broches de sortie nécessaires.

L'encapsulage des puces dans des boîtiers plastiques, tels que par exemple les boîtiers standards du type SOJ ("Small Outline J-lead"), TSOP ("Thin Small Outline Package") ou CSP ("Chip Scale Package") présente de nombreux avantages. Tout d'abord, ces boîtiers ont été testés et déverminés par le constructeur alors que ces opérations sont très difficiles à mener sur les puces nues. Par ailleurs, il est généralement difficile d'obtenir des puces nues auprès des constructeurs. L'ensemble de ces raisons conduit donc à privilégier l'utilisation de boîtiers, nettement moins coûteuse et plus facile.

L'empilage de boîtiers selon la solution du brevet mentionné plus haut implique les opérations principales suivantes : décambrage des broches de sortie pour faciliter le centrage et le moulage ; empilage des boîtiers plastiques ; enrobage par résine et polymérisation ; découpage du bloc ; métallisation ; gravure des contours des connexions sur les faces du bloc. D'autre part, comme le découpage s'effectue à l'extérieur des boîtiers pour utiliser les broches de sortie des boîtiers pour l'interconnexion en trois dimensions, le module en trois dimensions obtenu est toujours, dans le plan des boîtiers, de dimensions supérieures aux boîtiers d'origine.

L'invention a pour but, d'une part, de simplifier les opérations de fabrication d'un module 3D et, d'autre part de réduire notablement le volume occupé. Elle est basée sur l'idée de découper le bloc non plus à l'extérieur des boîtiers mais à travers ces boîtiers. Selon un aspect de l'invention, il est donc prévu un procédé d'interconnexion en trois dimensions selon la revendication 1. Pour interconnecter plusieurs boîtiers entre eux, on prévoit que ladite étape a) d'empilement et assemblage consiste à empiler et coller les boîtiers.

Grâce à ce procédé, on se dispense ainsi des opérations de décambrage des broches de sortie et d'enrobage et polymérisation, cette dernière étant remplacée par une simple opération de collage. On a ainsi simplifié le procédé.

D'autre part, le découpage du bloc s'effectue à proximité des puces, donc à travers les boîtiers, et non plus à l'extérieur des boîtiers d'où une réduction de près de 50 % de la surface du bloc dans un plan parallèle aux boîtiers.

Pour parvenir à cette solution aux problèmes de réduction de volume des dispositifs électroniques, il est clair qu'il a fallu d'une part aller à l'encontre de l'idée qu'un boîtier est nécessaire pour différentes fonctions de protection contre l'environnement extérieur, de manipulation non dangereuse pour la puce et de connexion électrique vers l'extérieur et ne doit pas être découpé et, d'autre part, qu'il a fallu constater que les résines de moulage-tranfert utilisées à l'intérieur des boîtiers par l'industrie des semi-conducteurs étaient sensiblement de même composition et teneur en charge que les résines d'enrobage utilisées dans l'art antérieur.

Une autre application particulièrement intéressante concerne le remplacement de composants complexes frappés d'obsolescence c'est-à-dire n'étant plus disponibles sur le marché, lorsque, par exemple, une nouvelle série d'un équipement ancien doit être mise en fabrication. Lors de la conception initiale de l'équipement, il a notamment pu être défini des circuits ASIC qui ont été réalisés par un fondeur qui, depuis, a changé de technologie. Jusqu'à maintenant, il était nécessaire de redévelopper un nouvel ASIC. Or, il existe des circuits intégrés programmables à mer de portes, du type FPGA ("Field Programmable Gate Array"), qui permettraient de programmer les mêmes fonctions que le circuit ASIC initial. L'inconvénient est que la disposition, le nombre de sorties et les dimensions du circuit ASIC sont différents de ceux des circuits FPGA disponibles : en général les circuits FPGA, à très haute intégration, ont un nombre de sorties nettement plus élevé que le circuit ASIC qu'on voudrait remplacer. La réalisation des fonctions d'un ASIC à 44 sorties par exemple n'utilisera que ce nombre de sorties d'un circuit FPGA (par exemple à 144 sorties). De plus la disposition de ces sorties ne sera pas la même, d'où une inadaptation à la carte où ce circuit doit être monté. Enfin, l'encombrement du circuit FPGA risque d'être différent et, en général, plus important.

L'invention permet, par son principe, de résoudre ces problèmes. Selon cette nouvelle application, on prévoit d'associer à un circuit complexe contenu dans un boîtier un circuit d'adaptation constitué d'un circuit imprimé, d'une première grille de conducteurs de sélection permettant de se relier aux sorties adéquates du boîtier et d'une seconde grille d'adaptation dont les broches reproduisent en nombre et disposition le motif souhaité, le circuit imprimé assurant l'interconnexion entre les deux grilles.

En procédant selon l'invention, on peut ainsi réaliser un circuit électronique à interconnexion en trois dimensions à faible encombrement, adapté à l'application souhaitée.

Selon cet autre aspect de l'invention, il est donc prévu un procédé tel que défini à la revendication 2. Empilement et assemblage consistent à empiler et assembler le circuit d'adaptation contre le boîtier par collage ou enrobage.

L'invention sera mieux comprise et d'autres caractéristiques et avantages apparaîtront à l'aide de la description ci-après et des dessins joints où :
- la Figure 1 est une vue de l'intérieur et de dessus d'un boîtier montrant les connexions d'une puce vers les broches de sortie ;
- la Figure 2 est une vue en coupe du boîtier de la Figure 1 selon le plan B ;
- la Figure 3 montre l'organigramme du procédé selon l'invention ;
- la Figure 4 est une vue en coupe de l'assemblage des boîtiers lors d'une étape du procédé selon l'invention ;
- la Figure 5 est une vue partielle en perspective du module 3D obtenu ;
- la Figure 6 illustre une étape initiale d'une variante d'application de l'invention ;
- les Figures 7 et 8 montrent des vues en coupe lors d'étapes successives de la variante de la Figure 6 ;
- la Figure 9 est une vue de côté du module obtenu ; et
- la Figure 10 est l'organigramme du procédé selon cette variante de l'invention.

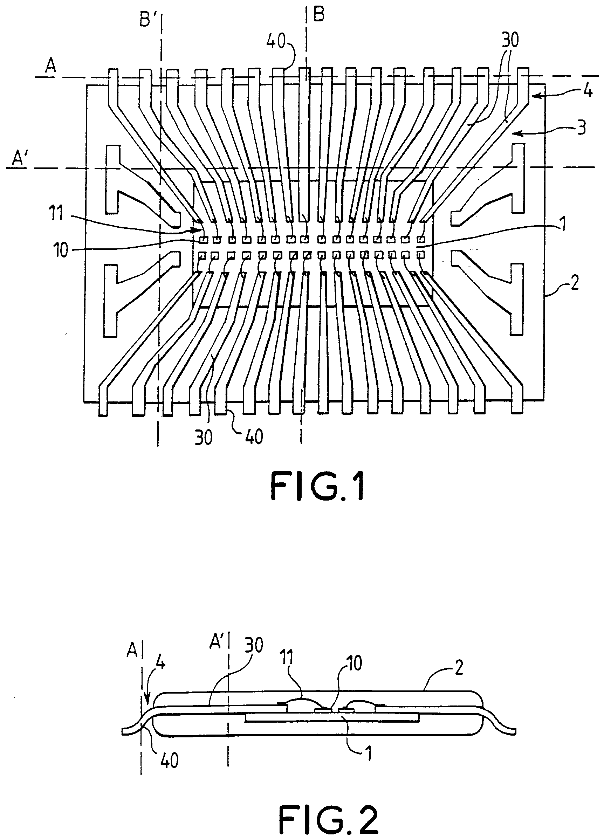

La Figure 1 représente à titre d'exemple et de manière simplifiée l'intérieur d'un boîtier TSOP vu de dessus. Une puce 1 (par exemple, mémoire) comporte des plots de connexion 10 alignés sur deux rangées. Ces plots sont reliés vers une grille 4 de broches de sortie 40 par l'intermédiaire d'un jeu 3 de conducteurs de connexion 30. La liaison entre les plots 10 et les conducteurs 30 s'effectue par câblage de fils 11. L'ensemble est enfermé dans un boîtier plastique 2.

La Figure 2 montre, en coupe selon le plan B, le boîtier 2. Les conducteurs 30 se terminent sur des broches de sortie cambrées 40.

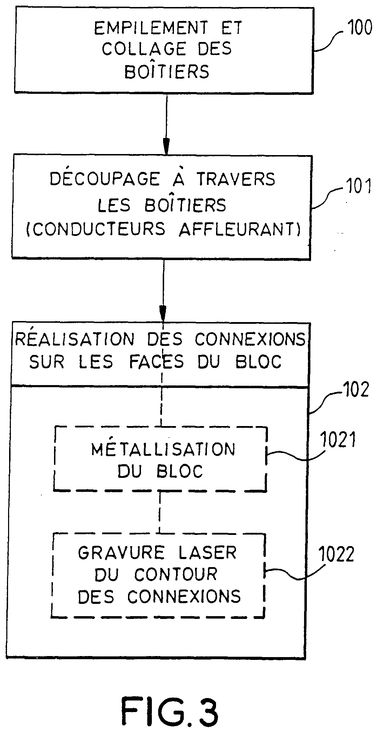

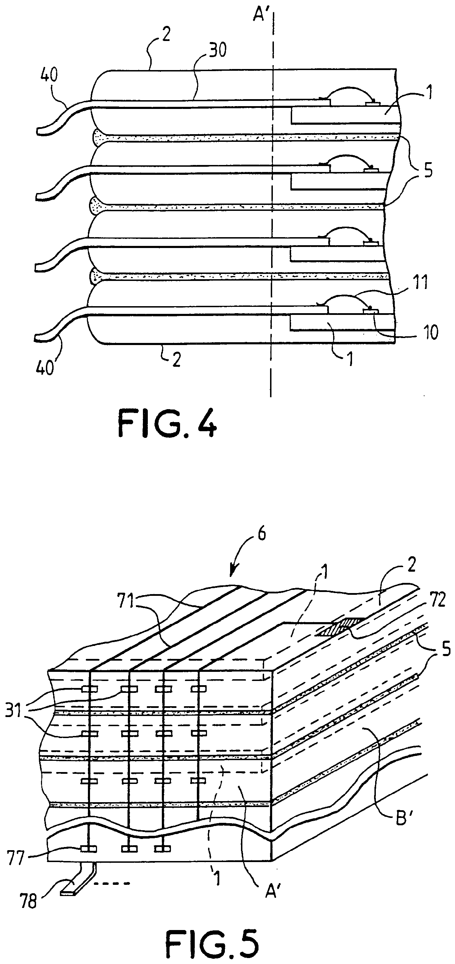

Le procédé selon l'invention, appliqué à l'interconnexion en trois dimensions de boîtiers entre eux, est illustré par l'organigramme de la Figure 3. Dans une première étape 100, les boîtiers sont empilés et assemblés par collage comme le montre la Figure 4, où la référence 5 désigne les films de colle entre les boîtiers.

Dans une seconde étape 101, on va découper l'ensemble, non pas au niveau des broches de sortie selon le plan A par exemple (Figure 1) comme dans l'art antérieur, mais à travers les boîtiers 2, selon le plan de coupe A' (ou B') à proximité de la puce 1 de manière à couper les conducteurs de connexion 30 dont la section 31 affleure les faces du bloc obtenu.

Comme on peut le constater, les plans de coupe tels A' ou B' sont beaucoup plus proches de la puce 1, d'où un encombrement considérablement réduit. Par exemple, le sciage peut s'effectuer à une distance entre 0,5 et 2 mm autour de la puce, selon les techniques de câblage des puces utilisées par le fabricant de semi-conducteurs.

L'étape 102 consiste ensuite à réaliser les connexions entre les conducteurs des différents boîtiers sur les faces du bloc obtenu. Diverses techniques sont utilisables pour cela. De préférence, dans un premier temps, on métallise, 1021, les faces du bloc et, dans un deuxième temps 1022, on grave le contour des connexions, par exemple par gravure laser. Le bloc 6 obtenu est représenté sur la Figure 5. On voit que les sections 31 des conducteurs de connexion des boîtiers 2 sont reliées par des connexions 71 sur les faces du bloc 6, qui peuvent aboutir à des plots de connexion vers l'extérieur 72 ou aux sections 77 des grilles 78 de sortie du bloc. Cette étape du procédé est décrite en détails par exemple dans le brevet précité FR 2 688 630.

Comme on peut le voir, le procédé selon l'invention permet de simplifier la fabrication des modules 3D en supprimant l'opération de décambrage des broches ou pattes de sortie, puisqu'elles sont éliminées lors du découpage et en remplaçant l'étape d'enrobage et de polymérisation par une seule opération de collage.

Une autre application de l'invention va maintenant être décrite dans le cadre du remplacement d'un circuit spécifique du type ASIC par un circuit d'application générale du type FPGA que l'on peut programmer pour réaliser les fonctions du circuit ASIC d'origine. Comme on l'a déjà expliqué, une telle programmation amène en général à n'utiliser qu'une partie des portes et des sorties du circuit FPGA et à re-répartir la disposition des sorties pour s'adapter à l'application envisagée.

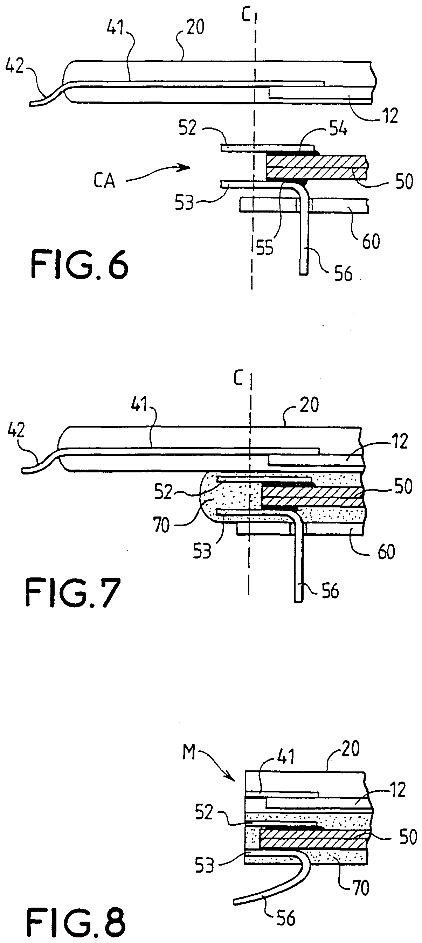

Pour cela, connaissant le nombre des sorties à utiliser et leur répartition, on réalise un circuit d'adaptation CA (Figure 6) qui comprend une première grille de sélection 52 disposée sur une face et sur les bords d'un circuit imprimé 50 en regard du boîtier 20 du circuit FPGA. Ce boîtier contient au moins une puce 12 dont les plots de connexion (non représentés) sont reliés aux broches 42 d'une grille de sortie par des conducteurs 41. Les broches 52 de la grille de sélection sont positionnées de façon à correspondre aux conducteurs 41 utilisés, dans ce qui sera le plan de coupe C. D'autre part, la face opposée du circuit imprimé 50 porte, sur ses bords, une grille d'adaptation de broches de sortie 53 dont le positionnement est celui des broches du circuit ASIC que l'on veut remplacer. L'interconnexion entre les deux grilles s'effectue grâce aux pistes du circuit imprimé 50. Les broches 52 sont soudées à ces pistes par les soudures 54 et les broches 53 par les soudures 55. Pour l'assemblage du boîtier et du circuit d'adaptation CA, on prévoit un support de grille 60 dans les fentes duquel l'extrémité 56 des broches de la grille 53 s'engage.

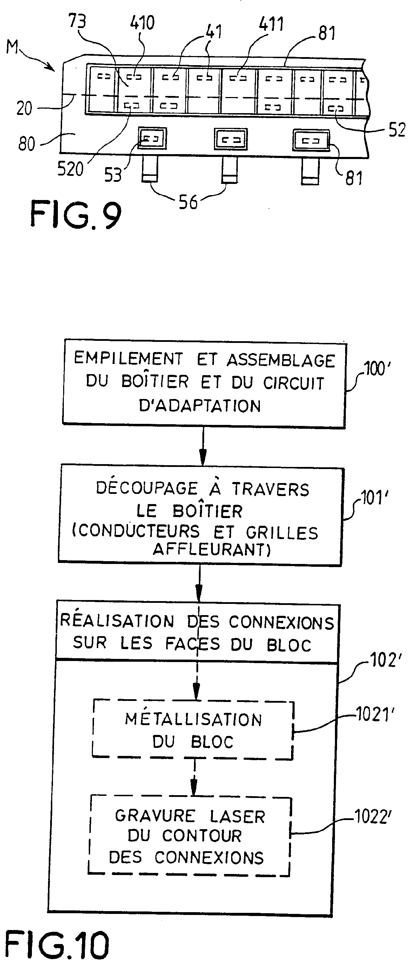

Dans une première étape 100' (Figure 10) on assemble le boîtier 20 et le circuit d'adaptation CA de manière que le plan de coupe C soit à proximité de la puce 12 et coupe les extrémités des grilles 52 et 53. L'assemblage se fait par exemple à l'aide de cordons de colle déposés sur les deux faces du circuit imprimé 50. La quantité totale de colle doit être suffisante pour remplir les volumes compris entre le circuit imprimé 50 et le boîtier 20 et le support de grille 60 respectivement et pour qu'un excès déborde en 70 lors de l'assemblage, de façon à permettre le sciage dans le coeur de la colle (sans vide ni trous). Sous la pression d'assemblage entre le boîtier 20 et le support 60, comme on vient de le dire, la colle déborde pour enrober les extrémités des broches 52 et 53, comme représenté en 70 sur la Figure 7. On peut aussi réaliser l'assemblage par enrobage entre boîtier et support 60 par une résine polymérisable, telle que de l'époxy.

L'étape suivante 101' consiste, comme précédemment, à découper à travers le boîtier selon le pian C.

On obtient alors, vu en coupe partielle sur la Figure 8, un bloc M où les conducteurs 41 et les broches des grilles 52 et 53 affleurent la face du bloc. Sur cette Figure 8, on a en outre représenté que l'extrémité 56 des broches de la grille d'adaptation a été cambrée convenablement.

L'étape 102' (Figure 10) consiste ensuite à réaliser sur les faces du bloc M les connexions souhaitées en trois dimensions entre les conducteurs 41 du boîtier et les broches de la première grille de sélection 52, en utilisant toute technologie classique.

Par exemple, on métallise (1021') les faces du bloc puis on grave (1022') les contours des connexions, par exemple par gravure laser.

La Figure 9 représente, vu de côté, le module M obtenu. Sur la face représentée, on voit les sections des conducteurs 41, de la grille de sélection 52 et de la grille d'adaptation 53. La métallisation 80 couvre toutes les faces du bloc M. Une gravure laser 81 permet de graver le contour des connexions entre conducteurs 41 et broches de la grille 52 et d'isoler les broches de la grille d'adaptation 53. Par exemple, une sortie utilisée 410 du boîtier est reliée par la connexion 73 à la broche 520. Par contre, des sorties telles 411 ne sont pas utilisées.

Bien entendu, les exemples de réalisation décrits ne sont nullement limitatifs de l'invention ; notamment on pourrait utiliser d'autres techniques que la métallisation complète du bloc pour réaliser les connexions en 3D ou on pourrait utiliser d'autres méthodes de gravure que celle par laser. On pourrait également prévoir de ne pas prolonger les broches 53 au delà du bord du circuit imprimé, ce qui éviterait de les voir affleurer et donc de devoir les isoler par gravure. Cependant, comme l'interconnexion entre la grille de sortie 56 et le circuit électronique 12 est réalisée grâce au brasage de la grille sur le circuit imprimé 50, pour des applications nécessitant une grande fiabilité sous environnement sévère, il n'est pas souhaitable que la brasure (étain/plomb dont le point de fusion est en général de 180° C) risque de refondre lorsque l'ensemble est lui-même brasé sur une carte de circuit imprimé comportant tous les autres composants. L'interconnexion par la face métallisée du bloc sécurise donc cette connexion de la grille 56. Mais pour de nombreuses applications non critiques, le fait de simplement braser la grille sur le circuit imprimé 50 constitue une réelle simplification.

## Revendications

1. Procédé d'interconnexion en trois dimensions pour au moins deux boîtiers plastique encapsulant (2) contenant chacun au moins une puce électronique (1), et muni chacun de conducteurs de connexion (30) pour relier, à l'intérieur de chaque boîtier, des plots de connexion (10) de la puce électronique à des broches de sortie (40) vers l'extérieur du boîtier, ledit procédé comportant les étapes suivantes :
a) empilement et assemblage (100) par collage des boîtiers;
b) découpage (101) à travers le plastique encapsulant des boîtiers, à une distance de la puce électronique comprise entre environ 0,5 et 2 mm, pour former un bloc (6) en laissant affleurer les sections (31) des conducteurs de connexion ;
c) réalisation (102) de connexions électriques (71) entre les sections (31) affleurant sur les faces dudit bloc.

2. Procédé d'interconnexion en trois dimensions pour au moins un boîtier plastique encapsulant (20) contenant au moins une puce électronique (12) et muni de conducteurs de connexion (41) à l'intérieur du boîtier, pour relier, à l'intérieur dudit boîtier, des plots de connexion de la puce électronique à des broches de sortie (42) vers l'extérieur du boîtier et un circuit d'adaptation (CA) constitué d'un circuit imprimé (50), d'une première grille (52) de sélection des broches de sortie dudit boîtier disposée sur les bords d'une face du circuit imprimé et d'une seconde grille (53, 56) d'adaptation disposée sur les bords de l'autre face du circuit imprimé, le procédé comportant les étapes suivantes :
a) empilement et assemblage (100') du circuit d'adaptation (CA) contre le boîtier (20) par collage ou enrobage de sorte que la face du circuit imprimé sur laquelle la première grille de sélection est disposée est placée en vis-à-vis du boîtier plastique encapsulant;
b) découpage (101') à travers le plastique encapsulant du boîtier et à travers le circuit d'adaptation, de manière à couper les extrémités des conducteurs de connexion et des grilles (52, 53) du circuit d'adaptation à une distance de la puce électronique comprise entre environ 0,5 et 2 mm, pour former un bloc (M) en laissant affleurer la section des conducteurs de connexion (41) et la section des broches des grilles (52, 53);
c) réalisation (102') de connexions électriques (73) entre les sections de conducteurs de connexion (41) et les sections de broches de la première grille (52) affleurant sur les faces dudit bloc.

3. Procédé selon l'une quelconque des revendications 1 et 2, **caractérisé en ce que** l'étape c) de réalisation des connexions électriques consiste à :
c.1) métalliser (1021 ; 1021') les faces dudit bloc ;
c.2) graver (1022 ; 1022') les contours desdites connexions (71, 73).

4. Procédé selon la revendication 3, **caractérisé en ce que** l'étape c.2) de graver les contours des connexions s'effectue par gravure laser.

## Patentansprüche

1. Verfahren zur dreidimensionalen Verbindung von mindestens zwei einkapselnden Kunststoffgehäusen (2), die jedes mindestens einen elektronischen Chip (1) enthalten und jedes mit Verbindungsleitern (30) versehen sind, um im Inneren jedes Gehäuses Bondkontakte (10) des elektronischen Chips mit Ausgangspins (40) zur Außenseite des Gehäuses zu verbinden, wobei das Verfahren die folgenden Schritte aufweist:
a) Stapeln und Zusammenfügen (100) durch Verkleben der Gehäuse;
b) Schneiden (101) durch den einkapselnden Kunststoff der Gehäuse, in einem Abstand von dem elektronischen Chip zwischen ca. 0,5 und 2 mm, um einen Block (6) zu bilden, indem die Schnittflächen (31) der Verbindungsleiter bündig auf gleicher Höhe liegen;
c) Herstellen (102) von elektrischen Verbindungen (71) zwischen den Schnittflächen (31), die bündig auf gleicher Höhe auf den Seiten des Blocks liegen.

2. Verfahren zur dreidimensionalen Verbindung für mindestens ein einkapselndes Kunststoffgehäuse (20), das mindestens einen elektronischen Chip (12) enthält und mit Verbindungsleitern (41) im Inneren des Gehäuses versehen ist, um im Inneren des Gehäuses Bondkontakte des elektronischen Chips mit Ausgangspins (42) zur Außenseite des Gehäuses zu verbinden, und eine Anpassungsschaltung (CA), die durch eine gedruckte Schaltung (50), ein erstes Auswahlraster (52) der auf den Rändern einer Seite der gedruckten Schaltung angeordneten Ausgangspins des Gehäuses und ein zweites, auf den Rändern der anderen Seite der gedruckten Schaltung angeordnetes Anpassungsraster (53, 56) gebildet wird, wobei das Verfahren die folgenden Schritte aufweist:
a) Stapeln und Zusammenfügen (100') der Anpassungsschaltung (CA) entgegen dem Gehäuse (20) durch Verkleben oder Einbetten derart, dass die Seite der gedruckten Schaltung, auf der das erste Auswahlraster angeordnet wird, gegenüber dem einkapselnden Plastikgehäuse angeordnet wird;
b) Schneiden (101') durch den einkapselnden Kunststoff des Gehäuses und durch die Anpassungsschaltung, um die Enden der Verbindungsleiter und der Raster (52, 53) der Anpassungsschaltung in einem Abstand zu dem elektronischen Chip zwischen ca. 0,5 und 2 mm zu schneiden, um einen Block (M) zu bilden, indem die Schnittfläche der Verbindungsleiter (41) und die Schnittfläche der Rasterpins (52, 53) bündig auf gleicher Höhe liegen;
c) Herstellen (102') von elektrischen Verbindungen (73) zwischen den Schnittflächen der Verbindungsleiter (41) und den Schnittflächen der Pins des ersten Rasters (52), die bündig auf gleicher Höhe auf den Seiten des Blocks liegen.

3. Verfahren nach einem der Ansprüche 1 und 2, **dadurch gekennzeichnet, dass** der Schritt c) des Herstellens der elektrischen Verbindung darin besteht:
c.1) die Seiten des Blocks zu metallisieren (1021; 1021');
c.2) die Konturen der Verbindungen (71, 73) zu ätzen (1022; 1022').

4. Verfahren nach Anspruch 3, **dadurch gekennzeichnet, dass** der Schritt c.2), die Konturen der Verbindungen zu ätzen, durch Laserätzung ausgeführt wird.

## Claims

1. Method of three-dimensional interconnection for at least two encapsulating plastic packages (2) each containing at least one electronic chip (1), and each provided with connection conductors (30) for connecting, inside of each package, connection pads (10) of the electronic chip to output pins (40) towards the outside of the package, said method comprising the following steps:
a) stacking and assembling (100) by bonding the packages;
b) cutting (101) through the encapsulating plastic of the packages, at a distance from the electronic chip ranging between approximately 0.5 and 2 mm, to form a block (6) by leaving the sections (31) of the connection conductors flush;
c) making (102) electrical connections (71) between the sections (31) flush on the faces of said block.

2. Method of three-dimensional interconnection for at least one encapsulating plastic package (20) containing at least one electronic chip (12) and provided with connection conductors (41) inside of the package, for connecting, inside of said package, connection pads of the electronic chip to output pins (42) towards the outside of the package and a matching circuit (CA) composed of a printed circuit (50), a first selecting grid (52) of the output pins of said package disposed on the edges of a face of the printed circuit and a second matching grid (53, 56) disposed on the edges of the other face of the printed circuit, the method comprising the following steps:
a) stacking and assembling (100') the matching circuit (CA) against the package (20) by bonding or covering in such a way that the face of the printed circuit on which the first selecting grid is disposed is placed facing the encapsulating plastic package;
b) cutting (101') through the encapsulating plastic of the package and through the matching circuit, so as to cut the ends of the connection conductors and the grids (52, 53) of the matching circuit at a distance from the electronic chip ranging between approximately 0.5 and 2 mm, to form a block (M) by leaving the section of the connection conductors (41) and the section of the grid pins (52, 53) flush;
c) making (102') electrical connections (73) between the sections of the connection conductors (41) and the sections of the pins of the first grid (52) flush on the faces of said block.

3. Method according to any one of claims 1 and 2, **characterised in that** the step c) of making the electrical connections consists of:
c.1) metallizing (1021; 1021') the faces of said block;
c.2) etching (1022; 1022') the outlines of said connections (71, 73).

4. Method according to claim 3, **characterised in that** step c.2) of etching the outlines of the connections is conducted by laser etching.
